**Europäisches Patentamt**

**European Patent Office**

**Office européen des brevets**

(11) Veröffentlichungsnummer: **0 033 474**

**A2**

# (12) EUROPÄISCHE PATENTANMELDUNG

(21) Anmeldenummer: **81100400.1**

(22) Anmeldetag: **20.01.81**

(51) Int. Cl.³: **H 01 L 33/00**
**G 02 B 7/26**

(30) Priorität: **30.01.80 DE 3003331**

(43) Veröffentlichungstag der Anmeldung:
**12.08.81 Patentblatt 81/32**

(84) Benannte Vertragsstaaten:
**AT BE CH DE FR GB IT LI NL SE**

(71) Anmelder: **SIEMENS AKTIENGESELLSCHAFT Berlin
und München**
**Postfach 22 02 61**
**D-8000 München 22(DE)**

(72) Erfinder: **Plihal, Manfred, Dr. Dipl.-Phys.**
**Sonnenspitzstrasse 13a**
**D-8000 München 82(DE)**

(72) Erfinder: **Goerne, Jan, Dipl.-Ing.**
**Heinrich-Vogl-Strasse 8**
**D-8000 München 71(DE)**

(54) Vorrichtung zur Kopplung einer Infrarotdiode mit einer als Lichtwellenleiter verwendeten Einzelglasfaser.

(57) Zur positionsgenauen Kopplung Einzelglasfaser-Infrarotdiode (Burrus-Typ) ist eine Koppelhülse vorgesehen, deren eine Öffnung genau auf einen Diodensockel abgestimmt ist, an dem die Diode mit ihrer lichtemittierenden Fläche genau konzentrisch und senkrecht zu dessen Achse befestigt ist und deren andere Öffnung zur Aufnahme eines Zylinderstiftes ausgebildet ist, der einen Lichtwellenleiterendabschnitt konzentrisch zu seinem Außenmantel enthält.

FIG 1

SIEMENS AKTIENGESELLSCHAFT    Unser Zeichen:
Berlin und München           VPA 80 P 6514 E

0033474

Vorrichtung zur Kopplung einer Infrarotdiode mit einer
als Lichtwellenleiter verwendeten Einzelglasfaser

Die Erfindung bezieht sich auf eine Vorrichtung zur
Kopplung einer als Lichtwellenleiter verwendeten Einzelglasfaser mit einer Infrarotdiode vom Burrus-Typ,
bei der die Infrarotdiode an der Stirnseite eines
zylindrischen Diodensockels befestigt und die Glasfaser mit einem Endabschnitt in der Bohrung eines
zylindrischen Stiftes gefaßt ist und eine hohlzylindrische Koppelhülse vorgesehen ist, deren Innenraum
auf einer Seite zur Aufnahme des Sockels und auf der
anderen Seite zur Aufnahme des Stiftes eingerichtet ist.

Eine solche, aus der DE-OS 29 22 949 bekannte Vorrichtung wird benötigt, wenn elektrische Signale in optische
Signale umgewandelt und über eine optische Übertragungsstrecke gesendet werden sollen. Dabei kommt es darauf
an, daß die lichtemittierende Fläche der Diode mit der
durch ihren Mittelpunkt und senkrecht zu ihr verlaufenden Achse genau auf die Achse eines Endabschnittes des
Lichtwellenleiters ausgerichtet ist, um die Koppelverluste möglichst gering zu halten. Bei der bekannten
Vorrichtung (DE-OS 29 22 949) kann dies dadurch erreicht
werden, daß die etwa in der Mitte der Stirnseite des
Diodensockels an diesem befestigte Diode unter Strom
gesetzt wird und daß dann der mit Spiel in der Koppelhülse steckende Diodensockel quer zur Achse des Sockels
solange verschoben wird, bis das aus dem Lichtwellenleiter an dem von der Koppelhülse abgewandten Ende austretende Licht, das von der Diode in den Lichtwellenleiter eingestrahlt wird, ein Maximum erreicht.

Es ist jedoch erwünscht, die Diode z.B. bei einem Defekt auswechseln zu können, ohne daß hierbei aufwendige Justierarbeiten dieser Art erforderlich sind.

Aufgabe vorliegender Erfindung ist es daher, eine Vorrichtung der eingangs genannten Art derart auszubilden, daß keine aufwendige Justierarbeiten zum Aufeinanderausrichten von Diode und Lichtwellenleiter (Glasfaser) erforderlich sind .

Erfindungsgemäß ergibt sich die Lösung dieser Aufgabe dadurch, daß der zylindrische Außenabschnitt des Diodensockels mit großer Präzision ausgebildet und die Diode mit ihrer lichtemittierenden Fläche genau rechtwinklig zu diesem Außenabschnitt und mit der Mitte der lichtemittierenden Fläche konzentrisch zur Achse des Außenabschnittes des Diodensockels an diesem fixiert ist und daß der Innenraum der Koppelhülse auf der einen Seite genau auf den zylindrischen Außenabschnitt des Diodensockels und auf der anderen Seite genau auf die Mantelfläche des Stiftes abgestimmt ist.

Auf diese Weise, d.h. dadurch, daß die Diode genau auf den Außenabschnitt des Diodensockels und die Glasfaser genau auf die zylindrische Außenfläche des zylindrischen Stiftes vorjustiert sind, wobei insbesondere die Justierung der Diode passiv erfolgen kann, also ohne daß die Diode zur Lichtemission angeregt werden muß, werden Glasfaser und Diode beim Einführen in die Koppelhülse aufeinander automatisch zwangsjustiert und damit jede Justierarbeit bei der Kopplung von Diode und Glasfaser vermieden.

In weiterer Ausgestaltung der Erfindung ist vorgesehen, daß die Diode auf einem ca. 150 µm dicken,aus Berillium-

**0033474**

oder Aluminiumoxid oder zumindest an seiner Außenseite aus Siliziumdioxid bestehenden Plättchen befestigt ist, das am Boden einer Vertiefung fixiert ist, die in die Stirnseite des Diodensockels eingearbeitet ist,

0033474

daß die Vertiefung mit Epoxydharz ausgefüllt ist und daß dabei die lichtemittierende Fläche der Diode von einer Epoxydharzschicht mit einer max. Dicke von 100 $\mu$m bedeckt ist, oder daß die Vertiefung durch ein mit dem Rand der Vertiefung verbundenes Glasplättchen abgedeckt ist und daß der Diodensockel in der Hülse durch Umbördeln eines über den eingesetzten Diodensockel überstehenden Hülsenrandes fixiert ist.

Ein Ausführungsbeispiel der Erfindung wird nachstehend anhand von zwei Figuren noch näher erläutert. Dabei zeigen

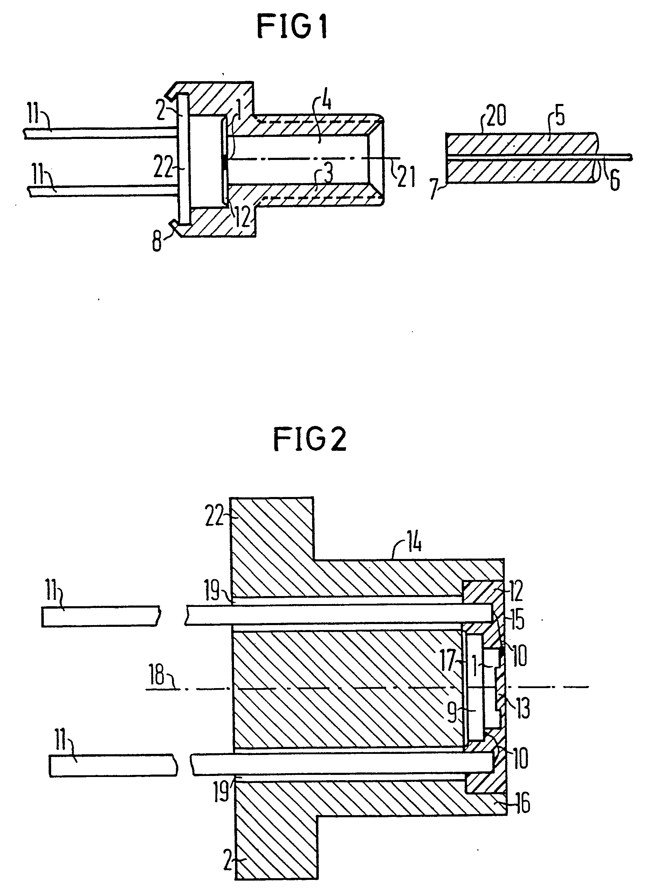

Fig. 1 die Vorrichtung in Seitenansicht, vergrößert, mit geschnittener Hülse und geschnittenem zylindrischem Stift und

Fig. 2 ebenfalls in Seitenansicht und besonders stark vergrößert den Diodensockel.

Im einzelnen ist den Figuren zu entnehmen, daß ein aus einem Metallkörper bestehender Diodensockel 2 vorgesehen ist, der einen zylindrischen Außenabschnitt 14 aufweist, der mit großer Präzision hergestellt worden ist. An einer rechtwinklig zu dem Außenabschnitt 14 verlaufenden Stirnseite 15 des Diodensockels 2 ist eine von einem Rand 16 des Diodensockels umgebene zylindrische Vertiefung 12 vorgesehen. In dieser Vertiefung 12 ist eine bei Stromdurchgang infrarotes Licht emittierende Diode vom Burrus-Typ angeordnet. Der Diodenkörper ist an einem 150 $\mu$ dicken Isolierstoffplättchen 9 fixiert, z.B. mit diesem verlötet, das seinerseits am Boden 17 der Vertiefung 12 befestigt z.B. verlötet ist. Das Plättchen kann vorteilhaft aus Berillium- oder Aluminiumoxid oder auch aus Silizium bestehen, das außen mit einer Siliziumdioxidschicht überzogen ist. Die Diode 1 ist dadurch gegenüber dem Metallkörper des Diodensockels 2 isoliert.

Die Befestigung der Diode 1 an dem Diodensockel muß so erfolgen, daß ihre lichtemittierende Fläche 13 rechtwinklig zur Achse 18 des zylindrischen Außenabschnittes 14 des Diodensockels 2 gerichtet ist und die Achse 18 durch die Mitte der Fläche 13 verläuft. Parallel zur Achse sind im Sockel 2 zwei Bohrungen 19 vorgesehen. In diesen Bohrungen 19 sind Anschlußstifte 11 isoliert befestigt, die in die Vertiefung 12 des Diodensockels 2 hineinragen und auf der anderen Seite des Sockels 2 aus diesem vorstehen.

Über Bond-Drähte 10 ist die Anode und die Kathode der Diode 1 jeweils mit einer Stirnseite der Anschlußstifte 11 verbunden , wobei einer dieser Drähte auf der vom Sockel 2 abgewandten Oberfläche der Diode 1 fixiert ist. Der die Vertiefung 12 umgebende Rand 16 des Sockels 2 ist so bemessen, daß er zumindest mit diesem Bond-Draht bündig ist. Die Vertiefung 12 ist mit einem Epoxydharz ausgegossen, wobei das Epoxydharz die lichtemittierende Fläche 13 der Diode 1 max. mit einer Schichtdicke von 100 $\mu$ überdeckt. Das Epoxydharz mit einem Brechungsindex von ca. 1,4 bildet dadurch einen guten Übergang zwischen dem Brechungsindex von ca. 3,5 des Diodenkörpers und dem Brechungsindex von ca. 1 für die zwischen der Diode und der Stirnseite der Glasfaser befindliche Luftstrecke.

Zur Verbindung des Lichtwellenleiters 6, dessen Durchmesser eher größer ist, als der Durchmesser oder die Diagonale der lichtemittierenden Fläche 13 der Diode 1, mit der Diode 1,ist eine hohlzylindrische Koppelhülse 3 vorgesehen, deren Innenraum 4 auf einer Seite der Hülse genau dem zylindrischen Außenabschnitt 14 des Diodensockels 2 angepaßt ist. Die andere Öffnung der Hülse 3 ist genau auf einen zylindrischen Stift 5 abgestimmt, in dem konzentrisch zum zylindrischen Mantel 20 des Stiftes 5 ein Endabschnitt des aus einer Einzelglasfaser bestehenden Lichtwellenleiters 6 derart fixiert ist, daß die Stirnseite des Lichtwellenleiters mit der Hülsenstirn 7 bündig ist.

Wird der Diodensockel 2 mit seiner Stirnseite 15 zur Koppelhülse 3 gerichtet,in den Teil des Hülseninnenraumes 4 eingesetzt, der dem zylindrischen Außenabschnitt 14 des Sockels angepaßt ist, so ist damit die lichtemittierende Fläche 13 der Diode exakt auf die Achse 21 der Koppelhülse 3 ausgerichtet. In gleicher Weise wird der Lichtwellenleiter 6 auf diese Achse 21 zentriert, wenn der Stift 5 in den Teil des Hülseninnenraumes 4 eingeschoben wird, der auf den Mantel 20 des Stiftes 5 abgestimmt ist.

Somit werden aber Lichtwellenleiter 6 und Diode 1, bzw. deren lichtemittierende Fläche 13, über die Koppelhülse 3 aufeinander zwangsjustiert und dadurch eine optimale Einkopplung des von der Diode 1 abgestrahlten Infrarotlichtes in den Lichtwellenleiter 6 gewährleistet, ohne daß es hierzu erforderlich ist, z.B. die lichtemittierende Diode 1 zu aktivieren und an den Lichtwellenleiter 6 ein Meßgerät anzuschließen und durch Positionsänderungen der Diode gegenüber der Stirnseite des Lichtwellenleiters 6 die optimale Position der Diode gegenüber dem Lichtwellenleiter 6 herauszufinden und zu fixieren.

Der Epoxydharzkörper, der die Vertiefung 12 ausfüllt, stellt darüber hinaus sicher, daß die lichtemittierende

0033474

Fläche 13 der Diode 1 und die Stirnseite des Lichtwellenleiters 6, in die das Diodenlicht einzukoppeln ist, in Richtung der Achse 21 optimal beabstandet sind, da der zylindrische Stift 5 mit dem Lichtwellenleiter 6 nur so weit in den Innenraum 4 der Koppelhülse eingeschoben werden kann, bis die Stirnseite 7 des Stiftes 5 an dem Epoxydharzkörper zur Anlage kommt.

Auf der von der Diode 1 abgewandten Seite ist der Sockel 2 mit einem Flansch 22 versehen. Der Flansch 22 bildet einen Anschlag beim Einsetzen des Diodensockels 2 in den Innenraum 4 der Hülse 3. Ein dabei über den Flansch 22 überstehender Hülsenrand 8 hält als Bördelrand den Diodensockel 2 in der Hülse 3 fest.

Der Stift 5 kann vorteilhaft Bestandteil einer Lichtwellenleitersteckverbindung sein und durch eine an dem Lichtwellenleitersteckverbindungsteil, der den Stift 5 enthält, drehbar befestigte Überwurfmutter, die mit der Hülse 3 verschraubt werden kann in der Hülse 3 festgelegt werden.

6 Patentansprüche
2 Figuren

0033474

## Bezugszeichenliste

| | |
|---|---|
| 1 | Diode |
| 2 | Diodensockel |
| 3 | Koppelhülse |
| 4 | Hülseninnenraum |
| 5 | zylindrischer Stift |
| 6 | Lichtwellenleiter-Einzelglasfaser |
| 7 | Stirnseite des Stiftes 5 |
| 8 | überstehender Bördelrand |
| 9 | Isolierstoffplättchen |
| 10 | Bond-Drähte |
| 11 | Anschlußstifte |
| 12 | Vertiefung im Diodensockel |
| 13 | lichtemittierende Fläche der Diode 1 |
| 14 | zylindrischer Außenabschnitt des Diodensockels |
| 15 | Stirnseite des Diodensockels |
| 16 | Rand des Diodensockels |
| 17 | Boden der Vertiefung |
| 18 | Achse des Diodensockels |
| 19 | Sockelbohrungen |
| 20 | Außenmantel des Stiftes 5 |
| 21 | Achse der Koppelhülse 3 |
| 22 | Sockelflansch |

<u>Patentansprüche</u>

1. Vorrichtung zur Kopplung einer als Lichtwellenleiter verwendeten Einzelglasfaser (6) mit einer Infrarotdiode (1) vom Burrus-Typ, bei der die Infrarotdiode (1) an der Stirnseite (15) eines zylindrischen Diodensockels (2) befestigt und die Glasfaser (6) mit einem Endabschnitt in der Bohrung eines zylindrischen Stiftes (5) gefaßt ist und eine hohlzylindrische Koppelhülse (3) vorgesehen ist, deren Innenraum (4) auf einer Seite zur Aufnahme des Sockels (2) und auf der anderen Seite zur Aufnahme des Stiftes (5) eingerichtet ist, d a d u r c h   g e - k e n n z e i c h n e t , daß der zylindrischen Außenab- schnitt (14) des Diodensockels (2) mit großer Präzision ausgebildet und die Diode (1) mit ihrer lichtemittierenden Fläche (13) genau rechtwinklig zu diesem Außenabschnitt (14) und mit der Mitte der lichtemittierenden Fläche (13) konzentrisch zur Achse (18) des Außenabschnittes (14) des Diodensockels (2) an diesem fixiert ist und daß der Innenraum (4) der Koppelhülse (3) auf der einen Seite genau auf den zylindrischen Außenabschnitt (14) des Diodensockels (2) und auf der anderen Seite genau auf die Mantelfläche (20) des Stiftes (5) abgestimmt ist.

2. Vorrichtung nach Anspruch 1, d a d u r c h   g e - k e n n z e i c h n e t , daß die Diode (1) auf einem ca. 150 µm dicken, aus Berillium- oder Aluminiumoxid oder zumindest an seiner Außenseite aus Siliziumdioxid bestehenden Plättchen befestigt ist, das am Boden einer Vertiefung (12) fixiert ist, die in die Stirnseite (15) des Diodensockels (2) eingearbeitet ist.

3. Vorrichtung nach einem der Ansprüche 1 oder 2, d a -
d u r c h   g e k e n n z e i c h n e t , daß die
Vertiefung (12) mit Epoxydharz ausgefüllt ist und daß
dabei die lichtemittierende·Fläche (13) der Diode (1)
von einer Epoxydharzschicht mit einer max. Dicke von
ca. 100  $\mu$m bedeckt ist.

4. Vorrichtung nach einem der Ansprüche 1 oder 2, d a -
d u r c h   g e k e n n z e i c h n e t , daß die Vertiefung (12) durch ein mit dem Rand (16) des Diodensockels (2) verbundenes Glasplättchen abgedeckt ist.

5. Vorrichtung nach einem der vorhergehenden Ansprüche,
d a d u r c h   g e k e n n z e i c h n e t , daß der
Diodensockel (2) in der Hülse (3) durch Umbördeln eines
über den eingesetzten Diodensockel (2) überstehenden
Hülsenrandes (8) fixiert ist.

FIG 1

FIG 2